# EUROPÄISCHE PATENTSCHRIFT

(11) **EP 3 486 670 B1**
(45) Veröffentlichungstag und Bekanntmachung des Hinweises auf die Patenterteilung: **01.09.2021**
(21) Anmeldenummer: 18206513.6
(22) Anmeldetag: 15.11.2018
(51) Int. Cl.: G01R 33/30

(54) **MAS-NMR-ROTORSYSTEM MIT VERBESSERTER RAUMNUTZUNG**
MAS-NMR ROTOR SYSTEM WITH IMPROVED SPACE UTILIZATION
SYSTÈME DE ROTOR RMN MAS À UTILISATION DE L'ESPACE AMÉLIORÉE

(30) Priorität: 20.11.2017 DE 102017220709
(43) Veröffentlichungstag der Anmeldung: 22.05.2019
(73) Patentinhaber: Bruker Switzerland AG, 8117 Fällanden (CH)
(72) Erfinder: Guidoulianov, Jevgeni, 8623 Wetzikon (CH); Freytag, Nicolas, 8122 Binz (CH)
(74) Vertreter: Kohler Schmid Möbus Patentanwälte

(56) Entgegenhaltungen:
- DE-A1-102015 208 850
- DE-B3-102013 201 110
- US-A- 4 940 942
- THURBER K R ET AL: "Biomolecular solid state NMR with magic-angle spinning at 25K", JOURNAL OF MAGNETIC RESONANCE, ACADEMIC PRESS, ORLANDO, FL, US, Bd. 195, Nr. 2, 23. September 2008 (2008-09-23), Seiten 179-186, XP025626038, ISSN: 1090-7807, DOI: 10.1016/J.JMR.2008.09.015 [gefunden am 2008-09-23]

## Beschreibung

Die Erfindung betrifft ein MAS-NMR-Rotorsystem, umfassend einen Rotor zur Aufnahme einer Messsubstanz und einen Stator zur Lagerung des Rotors drehbar um eine Rotationsachse,
mit einem ersten pneumatischen Radiallager, umfassend erste Düsenaustrittsöffnungen im Stator bei einem Radius r1 und eine erste Lagerfläche an einem kreiszylinderförmigen Abschnitt des Rotors bei einem Radius R1,
mit einem zweiten pneumatischen Radiallager, umfassend zweite Düsenaustrittsöffnungen im Stator bei einem Radius r2 und eine zweite Lagerfläche am Rotor bei einem Radius R2, gemessen gegenüber den zweiten Düsenaustrittsöffnungen im Stator,
und mit einem pneumatischen Axiallager, umfassend wenigstens eine Düsenaustrittsöffnung im Stator und eine dritte Lagerfläche an einem axialen Ende des Rotors, wobei die dritte Lagerfläche orthogonal zur Rotationsachse verläuft und einen Außenradius R3 aufweist.

Ein solches Rotorsystem ist beispielsweise aus der US 2016/0334478 A1 bekannt geworden.

Kernspinresonanz(=NMR, nuclear magnetic resonance)-Spektroskopie ist ein leistungsfähiges Verfahren der instrumentellen Analytik, mit der die chemische Zusammensetzung von Messsubstanzen (Proben) untersucht werden kann.

Dabei wird die Messsubstanz einem starken, statischen Magnetfeld ausgesetzt, wodurch es zur Ausrichtung von Kernspins in der Messsubstanz kommt. Nach Einstrahlung von HF(=Hochfrequenz)-Pulsen werden von der Messsubstanz ausgehende HF-Signale aufgenommen und zur Bestimmung der chemischen Zusammensetzung ausgewertet.

Bei der NMR-Spektroskopie von Festkörperproben kommt es zu einer erheblichen Linienverbreiterung in gemessenen NMR-Spektren aufgrund von anisotropen Wechselwirkungen zwischen Kernen in der Probe. Für Festkörperproben ist es bekannt, die Messsubstanz während der NMR-Messung unter dem so genannten "Magischen Winkel" von ca. 54,7° gegen die Richtung des statischen Magnetfelds zu rotieren. Dadurch kann eine Linienverbreiterung durch dipolare Wechselwirkungen, Quadrupolwechselwirkungen und den anisotropen Teil der chemischen Verschiebung reduziert bzw. bei ausreichend hohen Rotationsfrequenzen ausgelöscht werden.

Die Messsubstanz wird hierfür typischerweise in ein im Wesentlichen zylindrisches Probenröhrchen, genannt Rotor, gefüllt und in einen Stator verbracht. Der Rotor wird relativ zum Stator in Rotation versetzt, wobei der Rotor im Stator schwebt; hierfür werden geeignete Gasströme eingesetzt. Um HF-Pulse in die Messsubstanz einzustrahlen und/oder HF-Signale aus der Messsubstanz zu empfangen, ist eine HF-Spulenanordnung vorgesehen, die den Stator umgibt.

Aus der US 2016/0334478 A1 ist ein NMR-MAS-Probenkopf mit Rotor und Stator bekannt geworden, wobei zwei pneumatische Radiallager und ein Bodenlager ausgebildet sind. Zwischen den statorseitigen Teilen der Radiallager kann eine HF-Spulenanordnung angeordnet werden. Der Rotor ist zylinderförmig, mit gleichen Radien an beiden Radiallagern. Ebenso weisen die Düsenaustrittsöffnungen im Stator an beiden Radiallagern den gleichen Radius auf. Eine ähnliche Anordnung ist aus der DE 10 2013 201 110 B3 bekannt geworden.

Bei diesem NMR-MAS-Probenkopf befinden sich der Rotor und die HF-Spulenanordnung in der gleichen Umgebung bei Raumtemperatur. Um das Signal zu Rauschverhältnis der NMR-Messung zu verbessern, kann die HF-Spulenanordnung gekühlt werden. Um eine effiziente Kühlung zu erreichen, sollte dafür die HF-Spulenanordnung mit einer Isolation, etwa einer Vakuumisolation, versehen werden. Ein ähnlicher Aufbau ist bei der Messung von Messproben bei sehr hohen Temperaturen von Vorteil, bei denen der Messraum z.B. durch eine Vakuumisolation von der HF-Spulenanordnung thermisch getrennt werden kann.

Eine solche Isolation vergrößert aber den radialen Abstand zwischen dem Rotor bzw. der Messsubstanz und der HF-Spulenanordnung, d.h. die HF-Spulenanordnung muss mit einem größeren Durchmesser gewählt werden, von dem nur noch ein kleinerer Anteil mit Probensubstanz gefüllt ist. Weiterhin muss die HF-Spulenanordnung axial gegenüber dem Stator isoliert werden, was im Falle von radial ausgedehnten statorseitigen Radiallagerteilen zur Verkürzung der Spulenlänge und somit Reduktion des Messvolumens bei gleichem Messprobenvolumen führt. Bei einer dergestalteten Ausführung würden die Performance-Verluste aufgrund der geometrischen Nachteile den erzielbaren Gewinn durch die Reduktion des Rauschens aufgrund der gesenkten Temperatur der HF-Spulenanordnung weitestgehend aufheben oder sogar übersteigen. Zudem ist eine solche Isolation nur sehr schwer nachträglich in einem MAS-NMR-Probenkopf zu installieren.

Ein Rotorsystem mit zwei Radiallagern gleicher Radien und einem konusförmigen Bodenlager, das schräg angeblasen wird, ist aus der US 7,196,521 bekannt geworden. Aus der US 4,275,350 und der US 4,806,868 sind Rotorsysteme mit einem Radiallager und einem konusförmigen Antrieb bekannt geworden. Die US 4,739,270 beschreibt ein Rotorsystem mit zwei Radiallagern gleicher Radien, und mit einer endseitigen Verengung als Markierung für die Spinningdetektion. Die US 5,325,059 und die US 5,508,615 zeigen Rotorsysteme, wobei der Rotor endseitige Verengungen aufweist, an denen ein Antrieb wirkt; die Lagerung erfolgt mittels zwei Radiallagern auf gleichem, großen Durchmesser. Bei der US 6,054,857 erfolgt ein Antrieb über verengte endseitigen Kappen. Bei der US 6,803,764 weist der Rotor einenends eine Verengung auf, an der der Antrieb wirkt; die Lagerung erfolgt mittels zweier Radiallager auf gleichem, großen Durchmesser und mittels eines Bodenlagers.

Aus K. R. Thurber, R. Tycko, Journal of Magnetic Resonance 195 (2008), 179-186, ist NMR-MAS-Probenkopf bekannt geworden, bei dem ein Rotor mit zwei Radiallagern, die mit gleichem Radius ausgebildet sind, gehalten wird. Eine Kammer zwischen den Radiallagern, in dem ein mittlerer Teil des Rotors und und eine HF-Spule angeordnet sind, wird von kaltem Heliumgas durchströmt; Stickstoffgas wird für den Antrieb des Rotors an einer Rotorspitze und an den Radiallagern eingesetzt.

### Aufgabe der Erfindung

Der Erfindung liegt die Aufgabe zugrunde, ein MAS-NMR-Rotorsystem zur Verfügung zu stellen, mit dem eine HF-Spulenanordnung radial besonders nahe an eine Messsubstanz im Rotor heranrücken kann und die MAS-NMR-Rotorensystem leicht in die HF-Spulenanordnung ein- und ausführbar ist.

### Kurze Beschreibung der Erfindung

Diese Aufgabe wird auf überraschend einfache und wirkungsvolle Weise gelöst durch ein Rotorsystem der eingangs genannten Art, das dadurch gekennzeichnet ist, dass das zweite Radiallager an einem Endabschnitt des Rotors ausgebildet ist, der einen gegenüber dem kreiszylinderförmigen Abschnitt kleineren oder weg vom kreiszylindrischen Abschnitt sich verkleinernden Radius aufweist, so dass gilt R2 < R1 und weiterhin r2 < r1, und dass die dritte Lagerfläche an einem dem kreiszylinderförmigen Abschnitt abgewandten Ende des Endabschnitts ausgebildet ist, so dass weiterhin gilt R3 ≤ R2.

Gemäß der Erfindung ist vorgesehen, dass im Bereich des Endabschnitts, wo das zweite Radiallager ausgebildet ist, der Rotor gegenüber dem kreiszylindrischen Abschnitt verengt ist, entsprechend R2 < R1. Dadurch wird ein radialer Raum für die Ausbildung des statorseitigen Teils des zweiten Radiallagers zur Verfügung gestellt. Entsprechend kann das zweite Radiallager statorseitig enger ausgebildet werden als das erste Radiallager, gemäß r2 < r1.

Das erfindungsgemäße MAS-NMR-Rotorsystem, umfassend Rotor und Stator, kann dann einenends (vorne, im Bereich des zweiten pneumatischen Radiallagers) radial enger ausgebildet werden als anderenends (hinten, im Bereich des ersten pneumatischen Radiallagers). Dadurch kann das Rotorsystem gut mit dem vorderen Ende (also mit dem vorderen Endabschnitt und Teilen des kreiszylinderförmigen Abschnitts) in einen radial begrenzten Raum eingeführt werden, in welchen das hintere Ende (mit dem ersten pneumatischen Radiallager) nicht mehr hineinpassen würde.

Durch die erfindungsgemäße Geometrie kann eine HF-Spulenanordnung (ein HF-Spulensystem), in das der Stator und der Rotor in axialer Richtung eingeführt werden, sehr nahe an den Rotor bzw. die Messsubstanz heranrücken. Das nutzbare Volumen für Messsubstanz im Inneren der HF-Spulenanordnung wird nicht durch die radiale Breite des am zylindrischen Abschnitt wirkenden ersten pneumatischen Radiallagers, sondern nur durch die radiale Breite des am radial kleineren Endabschnitt angeordneten zweiten pneumatischen Radiallagers (oder durch den kreiszylinderförmigen Abschnitt selbst, sollte dieser eine größere radiale Breite aufweisen) bestimmt. Insgesamt ist ein sehr kompakter Aufbau des Rotorsystems möglich.

Wenn das Rotorsystem axial in eine HF-Spulenanordnung eingeführt wird, ist ein Austausch (evtl. auch eine Nachrüstung) des Rotorsystems in diese HF-Spulenanordnung im Allgemeinen sehr leicht möglich. Der Stator kann insbesondere gehandhabt (etwa eingeschoben oder herausgezogen) werden, ohne die HF-Spulenanordnung aus ihrem Probenkopf (auch genannt Probenkopfanordnung) entfernen zu müssen. Eine Isolation, etwa eine Vakuumisolation, für die HF-Spulenanordnung ist mittels oder unter Beteiligung des MAS-NMR-Rotorsystems sehr einfach einzurichten, insbesondere mit einer sich im Wesentlichen in axialer Richtung mit konstantem Innenradius erstreckenden Innenwand. Eine solche Isolation ist in Einzelfällen auch nachträglich leicht einzurichten, und besonders gut mit dem erfindungsgemäßen Rotorsystem nutzbar. Insbesondere kann ein Teil des Stators (etwa ein Hüllelement) als radial innenliegender Teil bzw. Wand einer Isolation einer HF-Spulenanordnung genutzt werden (mehr dazu unten).

Eine Verkleinerung des Radius R2 im Endabschnitt gegenüber dem Radius R1 im kreiszylinderförmigen Abschnitt entlang der axialen Richtung kann kontinuierlich oder abschnittsweise kontinuierlich oder auch mit einer oder mehreren Stufen erfolgen. Weiterhin kann der Übergang vom kreiszylindrischen Abschnitt zum Endabschnitt kontinuierlich oder auch mit einer Stufe erfolgen. Man beachte, dass die zweite Lagerfläche parallel zur Rotationsachse verlaufen kann, oder auch mit einem Konuswinkel zur Rotationsachse; das zweite Radiallager (und auch das erste Radiallager) hält den Rotor in radialer Richtung in Position. Der Radius Rᵢ der Lagerflächen bezieht sich auf die Position mittig bezüglich der zugehörigen Düsenaustrittsöffnungen; im Falle von mehreren Düsenaustrittsöffnungen an verschiedenen axialen Positionen bezieht sich der Radius der Lagerflächen auf einen mittlere axiale Position der Düsenaustrittsöffnungen. Entsprechendes gilt für die Radien rᵢ.

### Bevorzugte Ausführungsformen der Erfindung

### Ausführungsformen zur Gestaltung des Endabschnitts

Eine bevorzugte Ausführungsform des erfindungsgemäßen Rotorsystems sieht vor, dass der Endabschnitt zumindest teilweise kreiszylinderförmig ausgebildet ist. Dies ermöglicht statorseitig einen besonders einfachen Aufbau. Zudem können die radiale Lagerfunktion des zweiten Radiallagers und die axiale Lagerfunktion des Axiallagers voneinander getrennt eingestellt werden, wenn das zweite Radiallager im kreiszylinderförmigen Bereich des Endabschnitts eingereichtet ist. Der Endabschnitt kann vollständig kreiszylinderförmig ausgebildet sein, mit einer (rechtwinkligen) Stufe am Übergang zum kreiszylinderförmigen Abschnitt. Bei einer vorteilhaften Bauform weist der Endabschnitt einen kegelstumfförmigen Teil (Bereich) zum kreiszylinderförmgen Anbschnitt hin und einen kreiszylinderflörmigen Teil (Bereich) zum Axiallager hin auf.

Bei einer anderen Ausführungsform ist der Endabschnitt zumindest teilweise kegelstumpfförmig ausgebildet. Dies ermöglicht einen einfachen und großvolumigen Aufbau des Rotors. Der Endabschnitt kann insbesondere vollständig kegelstumpfförmig ausgebildet sein. Wenn das zweite Radiallager im kegelstumpfförmigen Bereich des Endabschnitts ausgebildet ist, kann das zweite Radiallager zusätzlich zum Axiallager zur axialen Lagerfunktion beitragen. Zudem kann das Einführen des Rotors in den Stator durch den als Führung wirkenden kegelstumpfförmigen Verlauf des Rotors erleichtert werden. Weiterhin wird die Bruchtendenz des Rotors an einem konischen Übergang bei Belastungen im Betrieb gegenüber einer rechtwinkligen Stufe, etwa bei einem vollständig kreiszylinderförmigem Endabschnitt, reduziert.

Bevorzugt ist eine Weiterbildung dieser Ausführungsform, wobei der Endabschnitt zumindest teilweise unter einem Winkel α gegenüber der Rotationsachse verläuft, mit 15° ≤ α ≤ 45°. Dieser Winkelbereich für einen kegelstumpfförmigen Endabschnitt (oder einem kegelstumpfförmigen Teil des Endabschnitts) ist in der Praxis bewährt, insbesondere um eine ausreichende radiale Lagerfunktion zu erzielen.

Eine andere, vorteilhafte Ausführungsform sieht vor, dass der Stator die dritte Lagerfläche und zumindest einen angrenzenden Teil des Endabschnitts, bevorzugt den gesamten Endabschnitt, becherförmig umschließt, wobei im Bereich der dritten Lagerfläche und/oder des Endabschnittes Luftaustrittsöffnungen im Stator vorgesehen sind. Dadurch lässt sich der Gasstrom (insbesondere für die radiale und axiale Lagerfunktion) besonders gut kontrollieren, und auch hohe Drehzahlen des Rotors können eingestellt und sicher beherrscht werden.

Bei einer bevorzugten Ausführungsform ist vorgesehen, dass der Endabschnitt sich über 1/4 der Länge des Rotors oder weniger erstreckt und/oder sich mindestens über 1/20 der Länge des Rotors erstreckt. Falls der Rotor eine Verschlusskappe oder auch einen Kappenaufsatz aufweist, gehören diese bei der Bestimmung der Länge des Rotors zu diesem dazu. Durch eine Ausdehnung des Endabschnitts auf 1/4 der Länge des Rotors oder weniger ist der kreiszylinderförmige Abschnitt entsprechend lang, und das für Messsubstanz zur Verfügung stehende Volumen kann sehr groß gewählt werden. Durch eine Ausdehnung des Endabschnitts auf wenigstens 1/20 der Länge kann eine gute mechanische Stabilität und insbesondere eine hohe Drehzahl erreicht werden.

### Weitere Ausführungsformen

Bevorzugt ist auch eine Ausführungsform, bei der der Rotor an einem der dritten Lagerfläche abgewandten Ende eine Öffnung zur Befüllung des Rotors mit Messsubstanz aufweist, und der Rotor eine Kappe aufweist, die die Öffnung des Rotors verschließt. Durch die Öffnung kann der Rotor mit Messsubstanz befüllt werden, und durch die Kappe (die meist aus einem Kunststoff besteht) leicht verschlossen werden. Dadurch, dass die Kappe am hinteren (der dritten Lagerfläche abgewandten) Ende vorgesehen ist, kann die Kappe den vergleichsweise großen Radius R1 nutzen, was die Auslegung und das Einführen der Kappe erleichtert. Man beachte, dass alternativ auch eine Kappe zum Verschließen des Rotors im Bereich der dritten Lagerfläche vorgesehen sein kann, oder auch der Rotor beispielsweise zugeschmolzen sein kann (wodurch eine Kappe zum Verschließen nicht gebraucht wird).

Bei einer bevorzugten Weiterbildung dieser Ausführungsform sind an der Kappe Gegenstrukturen, insbesondere Prallflächen oder Flügelflächen oder schneckenförmige Rillen, für einen pneumatischen Antrieb des Rotors ausgebildet. In die Kappe sind die Gegenstrukturen für einen pneumatischen Antrieb besonders einfach einzubringen; die Kappe nimmt eine Doppelfunktion (Verschluss und Antrieb) war. Der pneumatische Antrieb erfolgt typischerweise über einen von den pneumatischen Lagern separat einstellbaren Gasstrom, mit eigenen Gasaustrittsöffnungen (Düsen).

Bevorzugt ist auch eine Weiterbildung, bei der ein Außenradius R4 der Kappe im Wesentlichen dem Radius R1 entspricht. Dies trägt zu einem kompakten Bau bei. Weiterhin ist es vorteilhaft, wenn der Außenradius R4 < R1 ist. Bei dieser Ausführungsform kann der Impulsübertrag auf Flügel oder Prallflächen maximiert werden, da eine höhere Differenzgeschwindigkeit zwischen den Prallflächen und der Strömungsgeschwindigkeit des Antriebsgases erreicht werden kann.

Vorteilhaft ist zudem eine Weiterbildung, bei der der kreiszylindrische Abschnitt sich vom Endabschnitt bis zur Öffnung erstreckt. Dadurch kann bei hohem Volumen für die Messsubstanz ein nahes Heranrücken an die HF-Spulenanordnung eingerichtet werden.

Vorteilhaft ist auch eine Ausführungsform, bei der der Rotor im Bereich der dritten Lagerfläche geschlossen ausgebildet ist. Dadurch ist die Form des Rotors in diesem Bereich einfach und genau vorgebbar, was die Einstellung der (vor allem axialen) Lagerkräfte erleichtert. Insbesondere ist dies von Vorteil, um die Orthogonalität der axialen Lagerfläche in Bezug auf die Rotationsachse sicherzustellen. Falls gewünscht, kann die dritte Lagerfläche auch an einem Kappenaufsatz ausgebildet sein, der am vorderen Ende des Rotors befestigt wird; dieser Kappenaufsatz kann auch Prall- oder Flügelflächen bzw. schneckenförmige Rillen für einen pneumatischen Antrieb enthalten. Alternativ kann an diesem Ende auch eine (alternative oder weitere) Öffnung und eine (alternative oder weitere) Kappe vorgesehen sein, in der die axiale Lagerfläche integriert ist. Diese (alternative oder weitere) Kappe kann auch Prall- oder Flügelflächen bzw. schneckenförmigen Rillen für einen pneumatischen Antrieb enthalten. Für eine Kappe oder einen Kappenaufsatz mit Außenradius R5 gilt bevorzugt R5≤R2.

Besonders bevorzugt ist auch eine Ausführungsform, die vorsieht, dass das Rotorsystem weiterhin ein Gegenlager aufweist, das dem Axiallager gegenüber liegt. Das Gegenlager kann beispielsweise ausgebildet sein
- als pneumatisches Axiallager, insbesondere mit wenigstens einer Düsenaustrittsöffnung im Stator und mit einer vierten Lagerfläche an einem axialen Ende des Rotors, die orthogonal zur Rotationsachse verläuft,
- als pneumatisches Konuslager,
- als Lager auf Basis eines passiven Gegendruckaufbaus, insbesondere mit einem Stopfen oder einer Blende,
- als Lager auf Basis eines aktiven Gegendruckaufbaus, insbesondere mit einem beweglichen Stopfen, variabler Blende oder mit Luftanblasen ohne Lagerfläche.

Man beachte, dass das Axiallager typischerweise eine Haltekraft aufbringt (also den Rotor am vorderen Ende zum Stator zieht), während das Gegenlager typischerweise eine Gegenkraft aufbringt (also den Rotor am hinteren Ende vom Stator wegdrückt), um das Axiallager zu unterstützen, insbesondere wenn der Außenradius R3 recht klein sein sollte, insbesondere falls R3 ≤ ¾ * R1 oder sogar R3 ≤ ½*R1. Für kleine R1 kann die Haltekraft auch schon bei R3 ≤ R1 zu gering sein, um den Rotor in seinem kompletten Betriebsbereich im Stator zu halten.

### Erfindungsgemäße MAS-NMR-Probenkopfanordnungen

In den Rahmen der vorliegenden Erfindung fällt auch eine Probenkopfanordnung umfassend ein erfindungsgemäßes, oben beschriebenes Rotorsystem sowie eine HF-Spulenanordnung zum Einstrahlen von HF-Pulsen in die Messsubstanz im Rotor und/oder zum Empfangen von HF-Signalen aus der Messsubstanz im Rotor,
wobei der Stator eine erste Lagerbasis umfassend einen statorseitigen Teil des ersten Radiallagers, ein Hüllelement und eine zweite Lagerbasis umfassend einen statorseitigen Teil des zweiten Radiallagers aufweist,
wobei das Hüllelement die erste Lagerbasis und die zweite Lagerbasis miteinander verbindet,
wobei das Hüllelement einen vorderen Abschnitt aufweist, der sich an die zweite Lagerbasis anschließt und einen größten Außendurchmesser ADV aufweist,
und die zweite Lagerbasis einen größten Außendurchmesser AD2 aufweist,
und der Stator im Bereich des ersten Radiallagers einen größten Außendurchmesser AD1 aufweist,
und wobei die HF-Spulenanordnung einen kleinsten Innendurchmesser IDS aufweist,
mit AD1 > IDS und ADV < IDS und AD2 < IDS.

Der Stator kann bei der Montage der Probenkopfanordnung oder für Wartungszwecke in axialer Richtung in die HF-Spulenanordnung hineingeschoben oder aus der HF-Spulenanordnung herausgezogen werden, ohne dass die HF-Spulenanordnung aus der Probenkopfanordnung ausgebaut werden müsste, und wobei der größte Teil des Rotors bzw. der enthaltenen Messsubstanz radial sehr nahe an die HF-Spulenanordnung gebracht werden kann. Der vordere Abschnitt hat typischerweise eine Länge LV, mit LV ≥ 0,5 * LS, oder auch LV ≥ 1,0*LS, mit LS: Länge der HF-Spulenanordnung (im Falle mehrerer geschachtelter Teilspulen bezogen auf eine innerste Teilspule). Typischerweise ragt der Stator bis unmittelbar vor das erste Radiallager in die HF-Spulenanordnung hinein. Typischerweise gilt ADV = AD2; hierdurch kann meist eine optimale Raumausnutzung erreicht werden. Es kann jedoch auch ADV < AD2 vorgesehen sein, etwa wenn man im Betrieb Abstand zwischen der HF-Spulenanordnung und dem Hüllelement einrichten möchte und das Hüllelement nicht die zweite Lagerbasis umgreift; insbesondere kann dafür das Hüllelement im Anschluss an die zweite Lagerbasis verklebt oder verlötet sein oder beide zusammen aus einem Stück gefertigt werden. Weiterhin kann auch ADV > AD2 vorgesehen sein, insbesondere wenn das Hüllelement die zweite Lagerbasis umgreift.

Besonders bevorzugt ist eine Ausführungsform der erfindungsgemäßen Probenkopfanordnung, bei der das Hüllelement gasdicht ausgebildet ist. Dadurch kann das Hüllelement dazu beitragen, Gasströme am Rotor zu leiten, oder auch voneinander separate Gasräume einzurichten, um für MAS-NMR-Messungen optimierte Bedingungen einzurichten. Insbesondere kann der Rotor unabhängig von der HF-Spulenanordnung temperiert werden; beispielsweise kann der Rotor bzw. die Messsubstanz gekühlt werden. Außerdem können für Messungen mit gefährlichen Messsubstanzen das Volumen im Stator und die Gase, die in Kontakt mit den gefährlichen Messsubstanzen kommen können, vom restlichen Labor und dem Probenkopf separiert werden und insbesondere abgesaugt werden.

Bevorzugt ist eine Weiterbildung dieser Ausführungsform, die vorsieht, dass die HF-Spulenanordnung in einem evakuierten Raum angeordnet ist, der durch das Hüllelement mit begrenzt wird, und/oder die HF-Spulenanordnung auf eine kryogene Temperatur T gekühlt ist, insbesondere mit T ≤ 100 K, bevorzugt T ≤ 40 K oder sogar T ≤ 20 K. Das Hüllelement dient dann nicht nur als Strukturbauteil, das die Lagerbasen miteinander verbindet, um den Stator als Ganzes handhabbar zu machen, sondern (im eingeführten Zustand) auch als Trennwand zum evakuierten Raum. Dadurch kann in radialer Richtung ein besonders kompakter Bau erreicht werden. Durch die Kühlung der HF-Spulenanordnung kann das Signal zu Rausch-Verhältnis im aufgenommenen NMR-Spektrum verbessert werden.

### Erfindungsgemäße Verwendungen

In den Rahmen der vorliegenden Erfindung fällt schließlich auch eine Verwendung eines erfindungsgemäßen, oben beschriebenen Rotorsystems oder einer erfindungsgemäßen, oben beschriebenen Probenkopfanordnung zur Vermessung einer Messsubstanz, die in den Rotor eingefüllt ist, in einem MAS-NMR-Experiment, wobei der Rotor im Stator angeordnet ist und der Rotor um die Rotationsachse rotiert, bevorzugt mit einer Frequenz von wenigstens 1 kHz und besonders bevorzugt mit einer Frequenz von wenigstens 10 kHz. Der Rotor und der Stator des MAS-NMR-Rotorsystems können einfach entlang der Rotationsachse eingeführt werden, und die Messsubstanz kann radial nahe an die HF-Spulenanordnung gebracht werden. Das NMR-Experiment kann dann mit hohem Signal zu Rausch Verhältnis gemessen werden.

Bei einer bevorzugten Variante der erfindungsgemäßen Verwendung sind ein Gasfluss am ersten Radiallager und ein Gasfluss am zweiten Radiallager so gewählt, insbesondere unterschiedlich gewählt, so dass eine näherungsweise gleiche Lagersteifigkeit beider Radiallager erhalten wird. Dadurch kann eine sehr stabile Rotation mit hoher Drehzahl eingerichtet werden. Unterschiedlicher Gasfluss an den beiden Radiallagern kann beispielsweise durch verschiedene Lagerdüsendurchmesser und/oder Düsenlängen und/oder Spaltmaße, i.e. (r1 - R1)/2 ≠ (r2 - R2)/2, oder unterschiedliche Lagerdüsenanzahl bei gleichem Gasdruck, oder bei gleichen Lagerdüsendurchmessern und/oder Düsenlängen und/oder Spaltmaßen und gleicher Lagerdüsenanzahl durch unterschiedlichen Gasdruck an den beiden Radiallagern eingerichtet werden, oder auch durch eine Kombination dieser Varianten. Unterschiedlicher Gasdruck an den beiden Lagern kann entweder durch Beaufschlagung aus verschiedenen Quellen oder durch Einstellen mittels Druckminderern erreicht werden. Äquivalent können auch für rillenkompensierte oder poröse Lagerflächen die Eigenschaften durch Variation von Anzahl/Volumen der Rillen bzw. Porosität/Porengrösse angepasst werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:

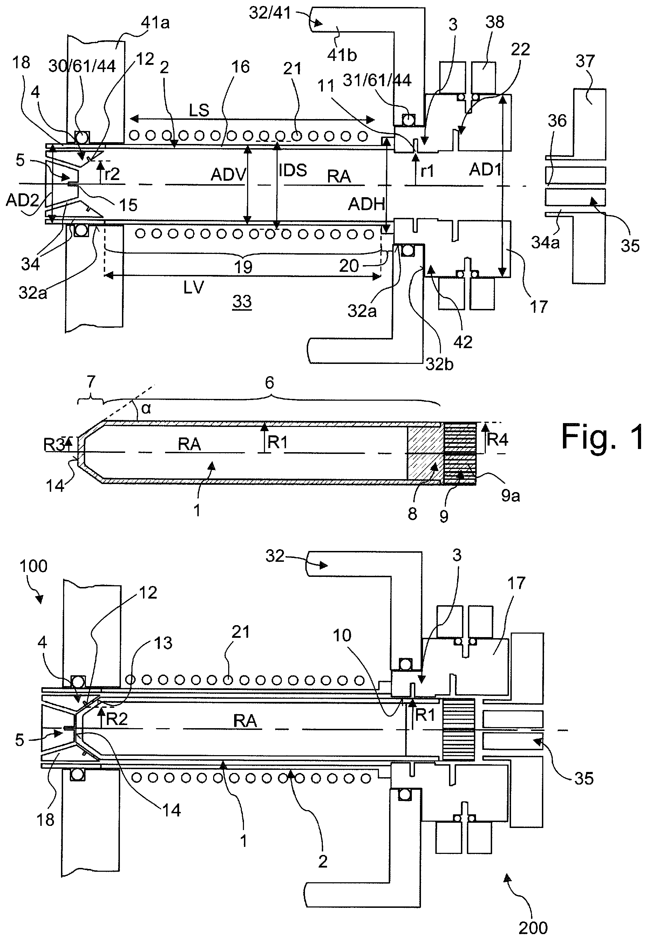

- Fig. 1: einen schematischen Querschnitt einer ersten Ausführungsform eines erfindungsgemäßen MAS-NMR-Rotorsystems, mit kegelstumpfförmigem vorderen Endabschnitt. Der Stator umfasst ein Hüllelement, ein Axiallager, zwei Radiallager und ein Gegenlager. Der Antrieb ist auf der dem Axiallager entgegengesetzten Seite ausgebildet. Die hier dargestellte Ausführungsform beinhaltet eine Fixierung des Stators im Stator-Halter über O-Ringe, jedoch darüber hinaus keine weitere Axialsicherung. Darüberhinaus ist eine HF-Spulenanordnung bestehend aus einer Drahtspule dargestellt;

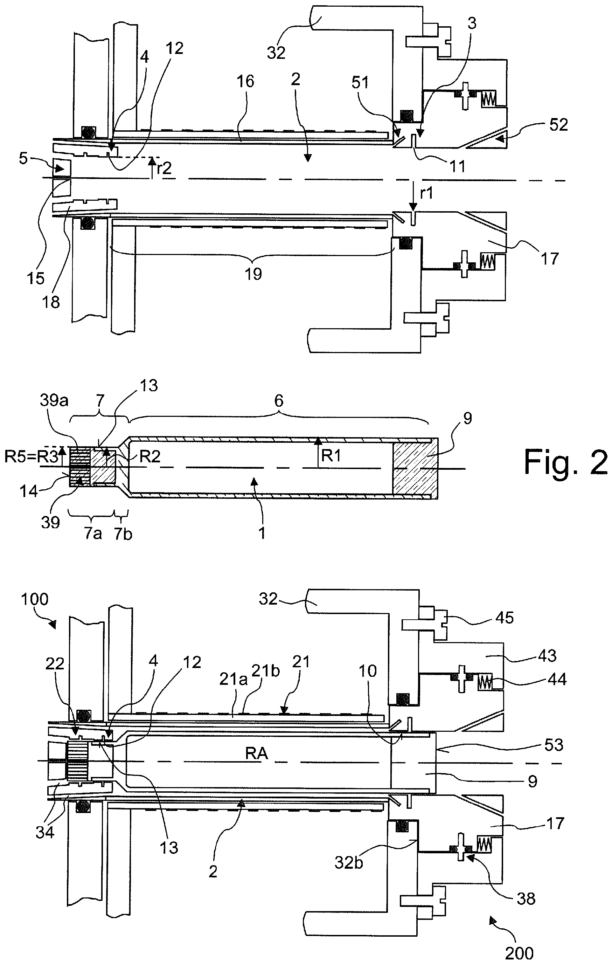

- Fig. 2: einen schematischen Querschnitt einer zweiten Ausführungsform eines erfindungsgemäßen MAS-NMR-Rotorsystems, mit größtenteils kreiszylinderförmigem vorderen Endabschnitt. Der Stator umfasst ein Hüllelement, ein Axiallager, zwei Radiallager und einen Antrieb, der im Bereich des vorderen Endabschnittes ausgebildet ist. Die hier dargestellte Ausführungsform beinhaltet eine Axialsicherung des Stators im Stator-Halter mittels Federkraft. Darüberhinaus ist eine HF-Spulenanordnung umfassend einen Spulenträger mit aufgebrachter HF-Spule dargestellt;

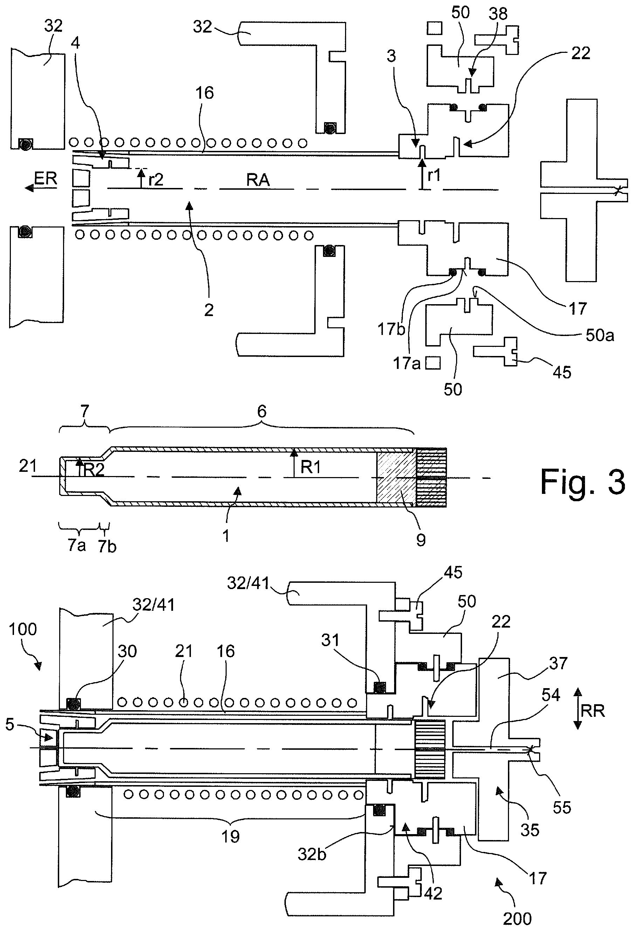

- Fig. 3: einen schematischen Querschnitt einer dritten Ausführungsform eines erfindungsgemäßen MAS-NMR-Rotorsystems, mit größtenteils kreiszylinderförmigem vorderen Endabschnitt. Der Stator umfasst ein Hüllelement, ein Axiallager, zwei Radiallager und einen Antrieb, der im hinteren Bereich des Rotors gegenüber dem Axiallager ausgebildet ist und eine Flussbegrenzung der Turbinenabluft zur Erhöhung der Haltekraft des Rotors im Stator aufweist. Die hier dargestellte Ausführungsform beinhaltet eine Axialsicherung des Stators im Statorhalter mittels der Gasanschlüsse für Lager und Antrieb;

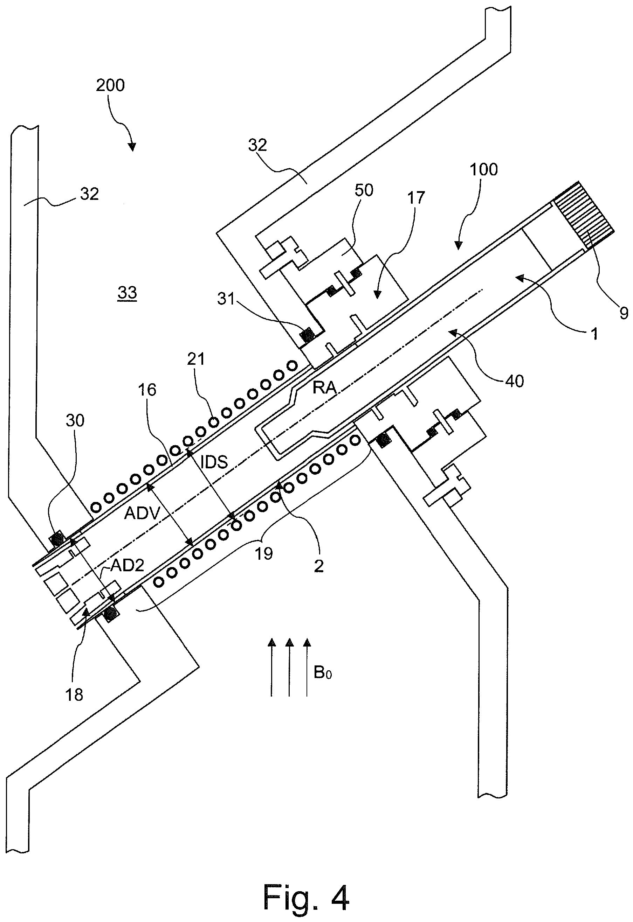

- Fig. 4: einen schematischen Querschnitt durch eine Ausführungsform einer erfindungsgemäßen Probenkopfanordnung, bei der der Stator in festem Winkel in Bezug auf die Probenkopfanordnung angebracht ist.

Fig. 1 zeigt eine erste Ausführungsform eines erfindungsgemäßen MAS-NMR-Rotorsystems 100, umfassend einen Rotor 1, in welchem eine Messsubstanz in fester oder semisolider Form (etwa ein Pulver oder Gel) angeordnet wird, und einen Stator 2. In Fig. 1 oben ist der Stator 2 (zusammen mit Teilen einer Stator-Halterung 32), in Fig. 1 Mitte der Rotor 1 und in Fig. 1 unten das gesamte MAS-NMR-Rotorsytem 100 mit Rotor 1 und Stator 2 (zusammen mit Teilen der Stator-Halterung 32) gezeigt. Das MAS-NMR-Rotorsystem 100 und die Stator-Halterung 32 sind Teil einer Probenkopfanordnung 200 gemäß der Erfindung.

Der Stator 2 umfasst ein erstes pneumatisches Radiallager 3, ein zweites pneumatisches Radiallager 4 und ein pneumatisches Axiallager 5. Der Rotor 1 ist innerhalb des Stators 2 um eine Rotationsachse RA drehbar gelagert.

Der Rotor 1 umfasst einen kreiszylinderförmigen Abschnitt 6 und einen Endabschnitt 7, der das in Fig. 1 linksseitige (vordere), geschlossene Ende des Rotors 1 bildet. Der Endabschnitt 7 verläuft hier kegelstumpfförmig und verjüngt sich auf das linksseitige Ende zu; ein Konuswinkel α des Endabschnitts 7 gegenüber der Rotationsachse RA beträgt hier ca. 30°; bevorzugt sind allgemein 10° bis 45°. Am rechtsseitigen (hinteren) Ende des Rotors 1 ist eine Öffnung 8 ausgebildet, die mit einer Kappe 9 verschlossen ist, so dass in den Rotor 1 eingefüllte Messsubstanz während eines NMR-Experiments nicht verloren geht. An der Kappe 9 sind Gegenstrukturen 9a, etwa Prallflächen ausgebildet (nur schematisch angedeutet), durch die mit einem geeigneten Gasstrom eines pneumatischen Antriebs 22 die Rotation des Rotors 1 um die Rotationsachse RA bewirkt werden kann. Der Außenradius R4 der Kappe 9 entspricht ungefähr dem Radius R1 des Rotors 1 im kreiszylinderförmigen Abschnitt 6.

Der kreiszylinderförmige Abschnitt 6 weist den (äußeren) Radius R1 auf und bildet eine erste Lagerfläche 10 für das erste pneumatische Radiallager 3 aus.

Statorseitige Düsenaustrittsöffnungen 11 (am inneren Ende der Düsenaustrittsbohrung) des ersten Radiallagers 3 sind auf einem Radius r1 bezüglich der Rotationsachse RA angeordnet.

Das zweite pneumatische Radiallager 4 verfügt über Düsenaustrittsöffnungen 12 bei einem Radus r2. Der Radius r2 ist deutlich kleiner als r1, hier mit ca. r2 = 0,65*r1. Der Radius R2 auf dem Endabschnitt 7 gegenüber den Düsenaustrittsöffnungen 12, wo eine zweite Lagerfläche 13 ausgebildet wird, beträgt deutlich weniger als R1, hier mit ca. R2 = 0,65*R1. Das zweite Radiallager 4 leistet hier nicht nur die radiale Lagerung des Rotors 1 im Bereich des vorderen Endes, sondern kann bei entsprechender Auslegung der Strömungsverhältnisse auch zum axialen Halten des Rotors 1 beitragen.

Am linksseitigen (vorderen) axialen Ende des Rotors 1 bildet der Rotor 1 eine dritte Lagerfläche 14 aus, die zusammen mit einer Düsenaustrittsöffnung 15 das pneumatische Axiallager 5 ausbildet. Die dritte Lagerfläche 14 liegt senkrecht zur Rotationsachse RA und weist einen Außenradius R3 auf, der wiederum deutlich kleiner ist als R1, hier mit ca. R3 = 0,5*R1.

Die statorseitigen Teile des zweiten Radiallagers 4 und des Axiallagers 5 umschließen becherförmig die dritte Lagerfläche 14 und hier auch den übrigen Endabschnitt 7. Zusätzlich zu den Düsenaustrittsöffnungen 12, 15 sind auch Abluftaustrittsöffnungen 34 im Stator 2 vorgesehen, um die Abluft vom Axiallager 5, vom zweiten Radiallager 4, je nach Ausführung aber auch, zumindest zu Teilen, vom ersten Radiallager 3 und zusätzlich eventuell vorhandene Temperierluft nach außen zu leiten. Dies dient dazu, einen Gegendruck zu vermeiden oder zu minimieren, der der Haltekraft des Axiallagers 5 entgegenwirken würde. Der Endabschnitt 7 erstreckt sich hier über ca. 6,5% der gesamten Länge des Rotors 1 (einschließlich Kappe 9); allgemein bevorzugt sind 5% bis 25%.

In der in Fig. 1 dargestellten Ausführungsform sind die statorseitigen Teile des zweiten Radiallagers 4 und des pneumatischen Axiallagers 5 so angeordnet, dass sie sich radial ungefähr genauso weit wie der Radius R1 des kreiszylinderförmigen Abschnitts 6 erstrecken. Insbesondere gilt hier r2 < R1.Hingegen nehmen die statorseitigen Teile des ersten Radiallagers 3 einen Raum jenseits von R1 ein.

Bevorzugt bildet der Stator 2 ein einheitliches Bauteil, wie in Fig. 1 ersichtlich (es ist aber auch möglich, den Stator 2 mit voneinander separaten Teilen auszubilden). Dazu verfügt der Stator 2 über ein Hüllelement 16, welches eine erste Lagerbasis 17, in der der statorseitige Teil des ersten Radiallagers 3 ausgebildet ist, und eine zweite Lagerbasis 18, in der der statorseitige Teil des zweiten Radiallagers 4 (und hier auch der statorseitige Teil des pneumatischen Axiallagers 5) ausgebildet ist, miteinander mechanisch verbindet. Das Hüllelement 16 verfügt über einen vorderen Abschnitt 19, der sich an die zweite Lagerbasis18 anschließt, und einen (größten) Außendurchmesser ADV aufweist, sowie hier über einen hinteren Abschnitt 20, mit einem (größten) Außendurchmesser ADH, der sich an das erste Lagerelement 17 anschließt. Der (größte) Außendurchmesser der ersten Lagerbasis 17 beträgt AD1, und der (größte) Außendurchmesser der zweiten Lagerbasis 18 beträgt AD2.

Der Stator 2 des MAS-NMR-Rotorsystems 100 durchragt mit der zweiten Lagerbasis 18 und dem vorderen Abschnitt 19 des Hüllelements 16 eine HF-Spulenanordnung 21, die einen kleinsten Innendurchmesser IDS aufweist. Der vordere Abschnitt 19 weist eine axiale Länge LV auf, die hier geringfügig größer ist als die axiale Länge LS der HF-Spulenanordnung 21. Die HF-Spulenanordnung ist hier als eine selbsttragende Drahtspule (ohne Spulenträger) ausgebildet.

Das MAS-NMR-Rotorsystem 100 wurde hier bis an den hinteren Abschnitt 20 axial (hier von der rechten Seite) in die HF-Spulenanordnung 21 hineingeschoben. Dafür ist eingerichtet, dass AD2 < IDS ist und auch ADV < IDS ist, wobei hier auch ADV = AD2 ist. Der Rotor 1 bzw. die enthaltene Messsubstanz kann radial sehr nahe an die HF-Spulenanordnung 21 heranrücken. Hingegen ist AD1 > IDS, so dass das erste Radiallager 3 mit einem großen Radius r1 der Düsenaustrittsöffnungen 11 ausgebildet sein kann, und auch AD1 > IDS eingerichtet werden kann, um die (hintere) radiale Lagerung des Rotors 1 zu verbessern. Für Wartungszwecke ist es ohne weiteres möglich, den Stator 2 aus der HF-Spulenanordnung 21 (hier nach rechts) axial herauszuziehen und nach einer Reparatur (oder einem Austausch, falls nötig) wieder in die HF-Spulenanordnung 21 hineinzuschieben (hier nach links), ohne die HF-Spulenanordnung 21 aus der MAS-NMR-Probenkopfanordnung 200 auszubauen.

Falls das Axiallager 5, ggf. zusammen mit dem Halte-Beitrag des zweiten Radiallagers 4, nicht ausreicht, um den Rotor 1 im Rotationsbetrieb in axialer Richtung in Position zu halten, kann (wie in Fig. 1 dargestellt) ein Gegenlager 35 vorgesehen sein, das am hier kappenseitigen Ende beispielsweise mit einem Gasstrom durch eine Düsenaustrittsöffnung 36 den Rotor 1 auf das Axiallager 5 zu schiebt. Das Gegenlager 35 kann in einem klappbaren oder verschiebbaren Statorteil ausgebildet sein, das für einen Statorwechsel weggeklappt oder weggeschoben werden kann oder bei jedem Rotorwechsel montiert, z.B. aufgeschraubt werden kann (nicht näher dargestellt). In der gezeigten Ausführungsform ist das Gegenlager 35 in einen Verschlussdeckel 37 integriert, mit dem der Stator 2 bei eingeführtem Rotor 1 verschlossen wird; der Verschlussdeckel 37 weist hier auch Luftauslassöffnungen 34a auf.

Der Stator 2 ist in einer Stator-Halterung 32 gelagert, die für den Stator 2 ein Stator-Lager 41 ausbildet, in das der Stator 2 axial (parallel zur Rotationsachse RA) ein- und ausgeführt werden kann; gezeigt ist in Fig. 1 oben und unten der eingeführte Zustand. Das Stator-Lager 41 umfasst hier einen vorderen Teil 41a, der in der gezeigten Ausführungsform die zweite Lagerbasis 18 umgreift und eine radiale Begrenzung 32a für eine etwaige radiale Bewegung des Stators 2 ausbildet. Weiterhin umfasst das Stator-Lager 41 hier einen hinteren Teil 41b, der in den gezeigten Ausführungsformen die erste Lagerbasis 17 umgreift und ebenfalls eine radiale Begrenzung 32a ausbildet. Der hintere Teil 41b bildet auch einen axialen Anschlag 32b für den Stator 2 aus, an dem eine Schulter 42 der ersten Lagerbasis 17 anliegt. Zwischen den Teilen 41a, 41b des Stator-Lagers 41, radial unmittelbar zum Hüllelement 16 benachbart, ist die HF-Spulenanordnung 21 angeordnet, die in nicht näher dargestellter Weise in der MAS-NMR-Probenkopfanordnung 200 befestigt ist, etwa an der Stator-Halterung 32 (nicht jedoch am Stator 2).

In den Teilen 41a, 41b des Stator-Lagers 41 sind Nuten vorgesehen, in denen Dichtungen (Dichtungsringe) 30, 31 angeordnet sind, hier O-Ringe aus elastischem Material, etwa Gummi. Diese drücken hier umlaufend auf die Außenseiten der zweiten Lagerbasis 18 und der ersten Lagerbasis 17. Dadurch wird ein evakuierter Raum 33, der radial innen durch das Hüllelement 16 mitbegrenzt wird, abgedichtet. In diesem evakuierten Raum 33 kann die enthaltene HF-Spulenanordnung 21 bei guter thermischer Isolation temperiert werden, insbesondere auf eine kryogene Temperatur von beispielsweise 20 K.

Die Dichtungen 31, 30 fungieren in der Ausführungsform von Fig. 1 als stationäre (d.h. in der Stator-Halterung 32 unbewegliche) Sicherungsteile 61, die gleichzeitig die Funktion von elastischen Elementen 44 haben, die den eingeführten Stator 2 radial verspannen und dadurch im Kraftschluss den Stator 2 axial fixieren, soweit dies im Normalbetrieb in Hinblick auf die dabei zu erwarteten Kräfte erforderlich ist. Mit größerer Kraft kann der Stator 2 jedoch axial (hier nach rechts) herausgezogen werden, etwa für eine Wartung, ohne dass weitere Mechanismen gelöst werden müssten. Man beachte, dass beim Wiedereinführen des Stators 2 in die Stator-Halterung 32 an den Dichtungen 31, 30 eine gewisse Kraft (mechanischer Widerstand) überwunden werden muss.

Am Stator 2, hier an der ersten Lagerbasis 17, ist zudem eine Gasstromversorgung 38 angeschlossen.

Die Fig. 2 zeigt eine zweite Ausführungsform eines erfindungsgemäßen MAS-NMR-Rotorsystems 100, welches weitgehend der Ausführungsform von Fig. 1 entspricht, so dass hier nur die wesentlichen Unterschiede dargestellt werden. Oben ist wiederum der Stator 2 (mit Teilen einer Stator-Halterung 32), in der Mitte der Rotor 1, und unten das MAS-NMR-Rotorsystem 100 mit Rotor 1 und Stator 2 gezeigt. Das MAS-NMR-Rotorsystem 100 und die Stator-Halterung 32 sind Teil einer Probenkopfanordnung 200 für die Erfindung.

In der gezeigten Ausführungsform weist der Rotor 1 einen Endabschnitt 7 auf, der in einem vorderen Teil 7a kreiszylinderförmig ausgebildet ist und in einem hinteren Teil 7b, der zum kreiszylinderförmigen Abschnitt 6 führt, konisch (kegelstumpfförmig) ausgebildet ist. Der Endabschnitt 7 bildet die zweite Lagerfläche 13 des zweiten pneumatischen Radiallagers 4 gegenüber den Düsenaustrittsöffnungen 12 im Bereich des kreiszylinderförmigen vorderen Teils 7a aus. Der Radius R2 der zweiten Lagerfläche 13 ist gleich dem Radius R3 der dritten Lagerfläche 14 des pneumatischen Axiallagers 5, gegenüber der Düsenaustrittsöffnung 15. Sowohl R2 als auch R3 sind deutlich kleiner als der Radius R1 der ersten Lagerfläche 10 gegenüber den Düsenaustrittsöffnungen 11 des ersten Radiallagers 3. Ein Teil des Endabschnitts 7 wird hier durch einen Kappenaufsatz 39 des Rotors 1 ausgebildet. Am Kappenaufsatz 39 sind Gegenstrukturen 39a, etwa Prallflächen, für einen Antriebsgasstrom eines Antriebs 22 ausgebildet, mit dem der Rotor 1 in Rotation um die Rotationsachse RA versetzt werden kann.

Die Düsenaustrittsöffnungen 12 des zweiten Radiallagers 4 liegen bei einem Radius r2 deutlich kleiner als der Radius r1 der Düsenaustrittsöffnungen 11 des ersten Radiallagers 3, und auch deutlich kleiner als der (äußere) Radius R1 des zylinderförmigen Abschnitts 6, so dass auch hier eine sehr kompakte Bauform erreichbar ist, die sich leicht in eine HF-Spulenanordnung 21 axial von der Seite einschieben lässt. Die HF-Spulenanordnung 21 ist hier mit einem rohrförmigen Spulenträger 21a ausgebildet, auf dem die Leiterelemente 21b der HF-Spulenanordnung 21 außenseitig angeordnet sind.

In der gezeigten Ausführungsform weist der Stator 2 Temperiergasdüsen 51 auf, mit denen im Stator 2 um den Rotor 1 herum, und dadurch auch im Rotor 1, eine gewünschte Temperatur einstellbar ist. Beispielsweise kann eine moderate Kühlung von Messsubstanz im Rotor 1 vorgenommen werden, um ein Denaturieren von Proteinen während einer NMR-Messung zu verhindern, beispielsweise bei ca. 0°C. Weiterhin sind hier Druckgasdüsen 52 vorgesehen, mit denen der Druck an einer Prallfläche 53 des Rotors 1, hier an der Kappe 9 ausgebildet, eingestellt werden kann, um die axiale Position des Rotors 1 während der Rotation um die Rotationsachse RA zu sichern.

Bei dieser Ausführungsform kann ein gleich großer oder größerer Gasstrom am zweiten Radiallager 4 eingesetzt als am ersten Radiallager 3, um eine näherungsweise gleiche Radiallagersteifigkeit zu erreichen. Insbesondere kann das zweite Radiallager 4 mit einem höheren Druck beaufschlagt werden als das erste Radiallager. Falls erforderlich, kann auch bei dieser Ausführungsform ein Gegenlager vorgesehen sein (nicht dargestellt, vgl. aber Fig. 1 und Fig. 3).

In der Ausführungsform von Fig. 2 ist ein abnehmbares Sicherungsteil 43 vorgesehen, welches den Stator 2 an der ersten Lagerbasis 17 hintergreift. Das abnehmbare Sicherungsteil 43 ist in einer sichernden, an der Stator-Halterung 32 verschraubten Stellung gezeigt, vgl. die Schrauben 45. Das Sicherungsteil 43 drückt mit elastischen Elementen 44, hier Federn oder alternativ Elastomerelementen, von hinten gegen den Stator 2, wodurch dieser am axialen Anschlag 32b anliegend fixiert wird. Der Stator 2 ist also elastisch gegen den axialen Anschlag 32b verspannt. Um den Stator 2 aus der Stator-Halterung 32 axial herauszuziehen (hier nach rechts), können die Schrauben 45 gelöst und das Sicherungsteil 43 (einschließlich Federn) entfernt werden.

Man beachte, dass das abnehmbare Sicherungsteil 43 hier auch eine Gasstromversorgung 38 beinhaltet.

Das Hüllrohr 16 weist hier keinen hinteren Abschnitt auf, der gegenüber einem vorderen Abschnitt 19 radial weiter wäre, insofern erstreckt sich hier der vordere (in die HF-Spulenanordnung einführbare) Abschnitt 19 über die gesamte Länge des Hüllrohrs 16.

Die **Fig. 3** zeigt eine dritte Ausführungsform eines erfindungsgemäßen MAS-NMR-Rotorsystems 100, welches weitgehend der Ausführungsform von Fig. 1 entspricht, so dass hier nur die wesentlichen Unterschiede dargestellt werden. Oben ist wiederum der Stator 2 gezeigt, jedoch in einem nur teilweise in Einführrichtung ER in die Stator-Halterung 32 eingeschoben Zustand, bei noch nicht montiertem Sicherungsteil 50. In der Mitte ist der Rotor 1 gezeigt, und unten das gesamte MAS-NMR-Rotorsystem 100 mit Rotor 1 und Stator 2. Das MAS-NMR-Rotorsystem 100 und die Stator-Halterung 32 sind Teil einer Probenkopfanordnung 200 für die Erfindung.

Bei dieser Bauform weist der Rotor 1 wiederum einen Endabschnitt 7 mit einem kreiszylinderförmigen vorderen Teil 7a und einem konischen hinteren Teil 7b auf (vgl. Fig. 2), jedoch ohne Verwendung eines Kappenaufsatzes am vorderen Ende. Der pneumatische Antrieb 22 greift an einer Kappe 9 am hinteren Ende des Rotors 1 an. Das Hüllrohr 16 weist hier keinen hinteren Abschnitt auf, der gegenüber einem vorderen Abschnitt 19 radial weiter wäre, insofern erstreckt sich hier der vordere (in die HF-Spulenanordnung 21 einführbare) Abschnitt 19 über die gesamte Länge des Hüllrohrs 16.

Das (hier mehrere separate Komponenten umfassende) Sicherungsteil 50 dient dazu, den Stator 2 im Statorlager 41 in einem axial (bezüglich Einführrichtung ER bzw. entlang der Rotationsachse RA) ganz eingefahrenen Zustand (vgl. Fig. 3 unten, mit Schulter 42 und axialem Anschlag 32b aneinander anliegend) zu sichern, so dass der Stator 2 sich während einer Messung axial nicht bewegen kann.

Das Sicherungsteil 50 weist Nasen 50a auf, die in Nuten 17a an der ersten Lagerbasis 17 einführbar sind. Im eingeführten Zustand der Nasen 50a kann das Sicherungsteil 50 mittels Schrauben 45 an der Stator-Halterung 32 angeschraubt werden, vgl. Fig. 3 unten für den eingeschraubten Zustand. Über in radialer Richtung RR eingepresste Dichtungen 17b, oder auch direkt über die Nasen 50a und einen jeweiligen Nutgrund der Nuten 17a, wird der Stator 2 in radialer Richtung RR eingeklemmt. Durch Kraftschluss wird dadurch auch eine weitere Sicherung des Stators 2 in axialer Richtung im Statorlager 41 erreicht, über die Wirkung der Dichtungen bzw. Dichtungsringe 30, 31 hinaus. Zudem hintergreifen die Nasen 50a auch die erste Lagerbasis 17 in den Nuten 17a bezüglich der axialen Richtung, wodurch eine zusätzliche Sicherung eintritt.

Das Sicherungsteil 50 beinhaltet hier auch die Gasstromversorgung 38, wobei die Dichtungen 17b den Versorgungsgasstrom abdichten.

Im Verschlussdeckel 37 ist hier ein Gegenlager 35 eingerichtet, indem der Abfluss der Antriebsluft des Antriebs 22 begrenzt wird, so dass ein Gegendruck aufgebaut wird, der den Rotor 1 auf das Axiallager 5 zu schiebt. In einem Gasauslasskanal 54 ist dafür eine verstellbare Gasstrom-Begrenzungseinrichtung, hier eine variable Blende 55, vorgesehen.

Fig. 4 zeigt in einer schematischen Schnittansicht eine Ausführungsform einer erfindungsgemäßen Probenkopfanordnung 200, in der ein erfindungsgemäßes MAS-NMR-Rotorsystem 100 verbaut wurde, wie in Fig. 3 dargestellt.

Die Probenkopfanordnung 200 umfasst einen Stator 2, in welchem ein Rotor 1 drehbar um eine Rotationsachse RA gelagert ist; der Rotor 1 wird in Fig. 4 gerade gewechselt und ist deshalb nur teilweise in den Stator 2 axial eingeschoben. Der Rotor 1 ist hinterenends mit einer Kappe 9 verschlossen. Der Stator 2 weist zwei Lagerbasen 17, 18, die über das Hüllelement 16 mechanisch verbunden sind.

Die Probenkopfanordnung 200 weist eine HF-Spulenanordnung 21 auf, wobei der kleinste Innendurchmesser IDS der HF-Spulenanordnung 21 größer als der (größte) Außendurchmesser AD2 der zweiten Lagerbasis 18 und der (größte) Außendurchmesser ADV in einem vorderen Abschnitt 19 des Hüllelements 16 (der hier die ganze Länge des Hüllelements 16 umfasst). Dadurch kann der Stator 2 bei der Montage oder zu Wartungszwecken bei entferntem Sicherungsbauteil 50 durch die HF-Spulenanordnung 21 hindurch geführt werden. Im eingeführten (eingeschobenen) Zustand wird der Stator 2 in einer Stator-Halterung 32 gehalten, die dafür ein Stator-Lager ausbildet. Die Lagerung ist so ausgebildet, dass die Rotationsachse RA unter dem magischen Winkel von 54,7° gegenüber einem hier vertikal verlaufenden Magnetfeld B₀ ausgerichtet ist.

Der nach radial außen gasdichte Stator 2 mit gasdichtem Hüllelement 16 ist hier im Bereich der Lagerbasen 17, 18 mit den Dichtungen 30, 31 gegenüber der Stator-Halterung 32 abgedichtet, so dass das der Stator 2 bzw. das Hüllelement 16 einen Raum 33 mitbegrenzt; der Raum 33 wird hier auch durch die Stator-Halterung 32 und weitere, nicht näher dargestellte Wände begrenzt. In dem Raum 33, der auch die HF-Spulenanordnung 21 enthält, ist hier ein Vakuum eingerichtet, um die HF-Spulenanordnung 21 thermisch zu isolieren. Dadurch ist es möglich, während einer MAS-NMR-Messung die HF-Spulenanordnung 21 auf eine kryogene Temperatur (beispielsweise 77 K, entsprechend flüssigem Stickstoff bei Normaldruck oder bei Kühlung z.B. mit flüssigem oder gasförmigem Helium auch tiefere Temperaturen, insbesondere ≤ 40 K, ≤ 20 K oder sogar im Bereich um 4,2 K, entsprechend flüssigem Helium bei Normaldruck) zu kühlen, während die Messsubstanz 40 im Rotor 1 auf einer Temperatur in der Nähe der Raumtemperatur bleibt bzw. auf eine Temperatur im Bereich von -250 °C bis + 1000 °C, insbesondere von -50°C bis + 150°C und besonders bevorzugt in einem Temperaturbereich von 0°C bis + 50°C temperiert werden kann.

Während der Messung rotiert der Rotor 1 im Stator 2 um die Rotationsachse RA, typischerweise mit einer Frequenz von 10 kHz oder mehr, insbesondere mit Drehzahlen im Bereich 1 kHz bis vs/(2π R1), wobei vs die Schallgeschwindigkeit des den Rotor 1 umgebenden Gases bei vorliegenden Druck/Temperaturbedingungen ist, und die HF-Spulenanordnung 21 strahlt HF-Pulse in die Messsubstanz 40 im Rotor 1 ein und/oder empfängt HF-Signale aus der Messsubstanz 40. Das starke statische Magnetfeld B₀ wirkt dabei (mit vertikaler Ausrichtung in Fig. 4) auf die Messsubstanz 40 ein.

Bevorzugt werden alle Gasströme an den beiden Enden des axial herausnehmbaren Stators 2 herausgeleitet, so dass es leicht gesammelt und rückgeführt werden kann. Dies ist insbesondere für Tieftemperatur-MAS vorteilhaft, um bei Betrieb mit He-Gas dieses nicht in die Raumluft zu verlieren. Bevorzugt wird das Gas unmittelbar in einen Dewar überführt, sodass es sich nicht unnötig aufwärmt und ein gekapselter Gaskreislauf möglich wird, der lediglich die Leitungsverluste und die Reibung im Rotorsystem 100 ausgleichen (nachkühlen) muss. Das Nachkühlen erfolgt bevorzugt mit Wärmetauschern und Kompression des Gases bei Raumtemperatur (nicht näher dargestellt).

Ebenso ist es von Vorteil, die Gasströme an beiden Enden des Stators 2 zu sammeln, für den Fall der Verwendung der MAS-NMR-Probenkopfanordnung 200 mit toxischen, kanzerogenen, explosiven, radioaktiven oder biogefährlichen Messproben.

### Bezugszeichenliste

- 1: Rotor
- 2: Stator
- 3: erstes pneumatisches Radiallager
- 4: zweites pneumatisches Radiallager
- 5: pneumatisches Axiallager
- 6: kreiszylinderförmiger Abschnitt
- 7: Endabschnitt
- 7a: vorderer Teil (Endabschnitt)
- 7b: hinterer Teil (Endabschnitt)
- 8: Öffnung
- 9: Kappe
- 9a: Gegenstrukturen
- 10: erste Lagerfläche
- 11: Düsenaustrittsöffnungen (erstes Radiallager)
- 12: Düsenaustrittsöffnungen (zweites Radiallager)
- 13: zweite Lagerfläche
- 14: dritte Lagerfläche
- 15: Düsenaustrittsöffnungen (Axiallager)
- 16: Hüllelement
- 17: erste Lagerbasis
- 17a: Nuten
- 17b: Dichtungen
- 18: zweite Lagerbasis
- 19: vorderer Abschnitt
- 20: hinterer Abschnitt
- 21: HF-Spulenanordnung
- 21a: Spulenträger
- 21b: Leiterelemente
- 22: pneumatischer Antrieb
- 30, 31: Dichtungen
- 32: Stator-Halterung
- 32a: radiale Begrenzung
- 32b: axialer Anschlag
- 33: evakuierter Raum
- 34: Luftauslassöffnungen
- 34a: Luftauslassöffnungen (Gegenlager)
- 35: Gegenlager
- 36: Düsenaustrittsöffnungen (Gegenlager)
- 37: Verschlussdeckel
- 38: Gasstromversorgung
- 39: Kappenaufsatz
- 39a: Gegenstrukturen
- 40: Messsubstanz
- 41: Stator-Lager
- 41 a: vorderer Teil (Stator-Lager)
- 41b: hinterer Teil (Stator-Lager)
- 42: Schulter
- 43: axial hintergreifendes Sicherungsteil
- 44: elastisches Element
- 45: Schraube
- 50: bewegliches Sicherungsteil
- 50a: Nasen
- 52: Druckgasdüsen
- 53: Prallfläche
- 54: Gasauslasskanal
- 55: variable Blende
- 61: stationäres Sicherungsteil
- 100: MAS-NMR-Rotorsystem
- 200: Probenkopfanordnung
- AD1: Außendurchmesser (erste Lagerbasis)
- AD2: Außendurchmesser (zweite Lagerbasis)
- ADV: Außendurchmesser vorderer Abschnitt
- ADH: Außendurchmesser hinterer Abschnitt
- ER: Einführrichtung
- IDS: kleinster Innendurchmesser (HF-Spulenanordnung)
- R1: Radius (erste Lagerfläche)
- R2: Radius (zweite Lagerfläche)
- R3: Außenradius (dritte Lagerfläche)
- R4: Radius (Kappe)
- R5: Radius (Kappenaufsatz)
- r1: Radius (Düsenaustrittsöffnungen erstes Radiallager)
- r2: Radius (Düsenaustrittsöffnungen zweites Radiallager)
- RA: Rotationsachse
- RR: radiale Richtung

## Patentansprüche

1. MAS-NMR-Rotorsystem (100), umfassend einen Rotor (1) zur Aufnahme einer Messsubstanz (40) und einen Stator (2) zur Lagerung des Rotors (1) drehbar um eine Rotationsachse (RA),
mit einem ersten pneumatischen Radiallager (3), umfassend erste Düsenaustrittsöffnungen (11) im Stator (2) bei einem Radius r1 und eine erste Lagerfläche (10) an einem kreiszylinderförmigen Abschnitt (6) des Rotors (1) bei einem Radius R1,
mit einem zweiten pneumatischen Radiallager (4), umfassend zweite Düsenaustrittsöffnungen (12) im Stator (2) bei einem Radius r2 und eine zweite Lagerfläche (13) am Rotor (1) bei einem Radius R2, gemessen gegenüber den zweiten Düsenaustrittsöffnungen (12) im Stator (2),
und mit einem pneumatischen Axiallager (5), umfassend wenigstens eine Düsenaustrittsöffnung (15) im Stator (2) und eine dritte Lagerfläche (14) an einem axialen Ende des Rotors (1), wobei die dritte Lagerfläche (14) orthogonal zur Rotationsachse (RA) verläuft und einen Außenradius R3 aufweist,
**dadurch gekennzeichnet,**
**dass** das zweite Radiallager (4) an einem Endabschnitt (7) des Rotors (1) ausgebildet ist, der einen gegenüber dem kreiszylinderförmigen Abschnitt (6) kleineren oder weg vom kreiszylindrischen Abschnitt (6) sich verkleinernden Radius aufweist, so dass gilt R2 < R1 und weiterhin r2 < r1,
und **dass** die dritte Lagerfläche (14) an einem dem kreiszylinderförmigen Abschnitt (6) abgewandten Ende des Endabschnitts (7) ausgebildet ist, so dass weiterhin gilt R3 ≤ R2.

2. Rotorsystem (100) nach Anspruch 1, **dadurch gekennzeichnet, dass** der Endabschnitt (7) zumindest teilweise kreiszylinderförmig ausgebildet ist.

3. Rotorsystem (100) nach Anspruch 1 oder 2, **dadurch gekennzeichnet, dass** der Endabschnitt (7) zumindest teilweise kegelstumpfförmig ausgebildet ist.

4. Rotorsystem (100) nach Anspruch 3, **dadurch gekennzeichnet, dass** der Endabschnitt (7) zumindest teilweise unter einem Winkel α gegenüber der Rotationsachse (RA) verläuft, mit 15° ≤ α ≤ 45°.

5. Rotorsystem (100) nach einem der vorhergehenden Ansprüche, **dadurch gekennzeichnet, dass** der Stator (2) die dritte Lagerfläche (15) und zumindest einen angrenzenden Teil des Endabschnitts (7), bevorzugt den gesamten Endabschnitt (7), becherförmig umschließt, wobei im Bereich der dritten Lagerfläche (14) und/oder des Endabschnittes (7) Luftaustrittsöffnungen (34) im Stator (2) vorgesehen sind.

6. Rotorsystem (100) nach einem der vorhergehenden Ansprüche, **dadurch gekennzeichnet, dass** der Endabschnitt (7) sich über 1/4 der Länge des Rotors (1) oder weniger erstreckt und/oder sich mindestens über 1/20 der Länge des Rotors (1) erstreckt.

7. Rotorsystem (100) nach einem der vorhergehenden Ansprüche, **dadurch gekennzeichnet, dass** der Rotor (1) an einem der dritten Lagerfläche (14) abgewandten Ende eine Öffnung (8) zur Befüllung des Rotors (1) mit Messsubstanz (40) aufweist, und dass der Rotor (1) eine Kappe (9) aufweist, die die Öffnung (8) des Rotors (1) verschließt.

8. Rotorsystem (100) nach Anspruch 7, **dadurch gekennzeichnet, dass** an der Kappe (9) Gegenstrukturen (9a), insbesondere Prallflächen oder Flügelflächen oder schneckenförmige Rillen, für einen pneumatischen Antrieb (22) des Rotors (1) ausgebildet sind.

9. Rotorsystem (100) nach Anspruch 7 oder 8, **dadurch gekennzeichnet, dass** ein Außenradius R4 der Kappe (9) im Wesentlichen dem Radius R1 entspricht.

10. Rotorsystem (100) nach einem der Ansprüche 7 bis 9, **dadurch gekennzeichnet, dass** der kreiszylindrische Abschnitt (7) sich vom Endabschnitt (7) bis zur Öffnung (8) erstreckt.

11. Rotorsystem (100) nach einem der vorhergehenden Ansprüche, **dadurch gekennzeichnet, dass** der Rotor (1) im Bereich der dritten Lagerfläche (14) geschlossen ausgebildet ist.

12. Rotorsystem (100) nach einem der vorhergehenden Ansprüche, **dadurch gekennzeichnet, dass** das Rotorsystem (100) weiterhin ein Gegenlager (35) aufweist, das dem Axiallager (5) gegenüber liegt.

13. Probenkopfanordnung (200) umfassend ein Rotorsystem (100) nach einem der vorhergehenden Ansprüche sowie eine HF-Spulenanordnung (21) zum Einstrahlen von HF-Pulsen in die Messsubstanz im Rotor (1) und/oder zum Empfangen von HF-Signalen aus der Messsubstanz (40) im Rotor (1),
wobei der Stator (2) eine erste Lagerbasis (17) umfassend einen statorseitigen Teil des ersten Radiallagers (3), ein Hüllelement (16) und eine zweite Lagerbasis (18) umfassend einen statorseitigen Teil des zweiten Radiallagers (4) aufweist,
wobei das Hüllelement (16) die erste Lagerbasis (17) und die zweite Lagerbasis (18) miteinander verbindet,
wobei das Hüllelement (16) einen vorderen Abschnitt (19) aufweist, der sich an die zweite Lagerbasis (18) anschließt und einen größten Außendurchmesser ADV aufweist,
und die zweite Lagerbasis (18) einen größten Außendurchmesser AD2 aufweist,
und der Stator (2) im Bereich des ersten Radiallagers (3) einen größten Außendurchmesser AD1 aufweist,
und wobei die HF-Spulenanordnung (21) einen kleinsten Innendurchmesser IDS aufweist,
mit AD1 > IDS und ADV < IDS und AD2 < IDS.

14. Probenkopfanordnung (200) nach Anspruch 13, **dadurch gekennzeichnet, dass** das Hüllelement (16) gasdicht ausgebildet ist.

15. Probenkopfanordnung (200) nach Anspruch 14, **dadurch gekennzeichnet, dass** die HF-Spulenanordnung (21) auf eine kryogene Temperatur T gekühlt ist, insbesondere mit T ≤ 100 K, bevorzugt T≤ 40 K, und /oder dass die Probenkopfanordnung einen evakuierten Raum umfasst, in dem die HF-Spulenanordnung (21) angeordnet ist und der durch das Hüllelement (16) mit begrenzt wird.

16. Verwendung eines Rotorsystems (100) nach einem der Ansprüche 1 bis 12 oder einer Probenkopfanordnung (200) nach einem der Ansprüche 13 bis 15 zur Vermessung einer Messsubstanz (40), die in den Rotor (1) eingefüllt ist, in einem MAS-NMR-Experiment, wobei der Rotor (1) im Stator (2) angeordnet ist und der Rotor (1) um die Rotationsachse (RA) rotiert, bevorzugt mit einer Frequenz von wenigstens 1 kHz und besonders bevorzugt mit einer Frequenz von wenigstens 10 kHz.

17. Verwendung nach Anspruch 16, **dadurch gekennzeichnet, dass** ein Gasfluss am ersten Radiallager (3) und ein Gasfluss am zweiten Radiallager (4) so gewählt sind, insbesondere unterschiedlich gewählt sind, so dass eine näherungsweise gleiche Lagersteifigkeit beider Radiallager (3, 4) erhalten wird.

## Claims

1. A MAS-NMR rotor system (100), comprising a rotor (1) for accommodating a measurement substance (40) and a stator (2) for mounting of the rotor (1) so as to be rotatable about a rotation axis (RA),
having a first pneumatic radial bearing (3), comprising first nozzle outlet openings (11) in the stator (2) at a radius r1 and a first bearing surface (10) on a circular cylindrically-shaped section (6) of the rotor (1) at a radius R1, having a second pneumatic radial bearing (4), comprising second nozzle outlet openings (12) in the stator (2) at a radius r2 and a second bearing surface (13) on the rotor (1) at a radius R2, measured opposite to the second nozzle outlet openings (12) in the stator (2),
and having a pneumatic axial bearing (5), comprising at least one nozzle outlet opening (15) in the stator (2) and a third bearing surface (14) on an axial end of the rotor (1), wherein the third bearing surface (14) runs orthogonally to the rotation axis (RA) and has an outer radius R3,
**characterized in that**
the second radial bearing (4) is formed on an end section (7) of the rotor (1) which, as compared to the circular cylindrically-shaped section (6), has a smaller radius or a radius that decreases away from the circular cylindrically-shaped section (6), so that R2 < R1 applies and also r2 < r1,
and that the third bearing surface (14) is formed on an end of the end section (7) that faces away from the circular cylindrically-shaped section (6), so that R3 ≤ R2 also applies.

2. The rotor system (100) according to Claim 1, **characterized in that** the end section (7) is at least partially circularly cylindrical in shape.

3. The rotor system (100) according to Claim 1 or 2, **characterized in that** the end section (7) is at least partially truncated conical in shape.

4. The rotor system (100) according to Claim 3, **characterized in that** the end section (7) runs at least partially at an angle α relative to the rotation axis (RA), where 15° ≤ α ≤ 45°.

5. The rotor system (100) according to one of the preceding claims, **characterized in that** the stator (2) encompasses the third bearing surface (15) and at least an adjoining portion of the end section (7), preferably the entire end section (7), in a cupular manner, wherein air outlet openings (34) are provided in the stator (2) in the area of the third bearing surface (14) and/or of the end section (7).

6. The rotor system (100) according to one of the preceding claims, **characterized in that** the end section (7) extends over % of the length of the rotor (1) or less and/or extends at least over 1/20 of the length of the rotor (1).

7. The rotor system (100) according to one of the preceding claims, **characterized in that** the rotor (1) includes an opening (8) at an end that faces away from the third bearing surface (14) for filling the rotor (1) with measurement substance (40), and that the rotor (1) includes a cap (9), which seals the opening (8) of the rotor (1).

8. The rotor system (100) according to Claim 7, **characterized in that** counter structures (9a), in particular impact surfaces or wing surfaces or spiral grooves, are formed on the cap (9) for a pneumatic drive (22) of the rotor (1).

9. The rotor system (100) according to Claim 7 or 8, **characterized in that** an outer radius R4 of the cap (9) corresponds essentially to the radius R1.

10. The rotor system (100) according to one of Claims 7 through 9, **characterized in that** the circular cylindrically-shaped section (7) extends from the end section (7) to the opening (8).

11. The rotor system (100) according to one of the preceding claims, **characterized in that** the rotor (1) is closed in the area of the third bearing surface (14).

12. The rotor system (100) according to one of the preceding claims, **characterized in that** the rotor system (100) further includes a counter bearing (35), which lies opposite the axial bearing (5).

13. A probe head assembly (200), comprising a rotor system (100) according to one of the preceding claims, as well as a RF coil arrangement (21) for irradiating RF pulses into the measurement substance in the rotor (1) and/or for receiving RF signals from the measurement substance (40) in the rotor (1), wherein the stator (2) includes a first bearing base (17), comprising a portion of the first radial bearing (3) on the stator side, a sheath element (16) and a second bearing base (18), comprising a portion of the second radial bearing (4) on the stator side,
wherein the sheath element (16) connects the first bearing base (17) and the second bearing base (18) to one another,
wherein the sheath element (16) includes a front section (19), which connects to the second bearing base (18) and has a maximum outer diameter ADV, and the second bearing base (18) has a maximum outer diameter AD2, and the stator (2) has a maximum outer diameter AD1 in the area of the first radial bearing (3),
and wherein the RF coil arrangement (21) has a minimum inner diameter IDS, where AD1 > IDS and ADV < IDS and AD2 < IDS.

14. The probe head assembly (200) according to Claim 13, **characterized in that** the sheath element (16) is gas-tight.

15. The probe head assembly (200) according to Claim 14, **characterized in that** the RF coil arrangement (21) is cooled to a cryogenic temperature T, in particular where T ≤ 100 K, preferably T ≤ 40 K, and/or that the probe head assembly comprises an evacuated space, in which the RF coil arrangement (21) is arranged and which is co-delimited by the sheath element (16).

16. Use of a rotor system (100) according to one of the Claims 1 through 12 or a probe head assembly (200) according to one of Claims 13 through 15 for measuring a measurement substance (40), which is introduced into the rotor (1), in a MAS-NMR experiment, wherein the rotor (1) is situated in the stator (2) and the rotor (1) rotates about the rotation axis (RA), preferably at a frequency of at least 1 kHz and particularly preferably at a frequency of at least 10 kHz.

17. Use according to Claim 16, **characterized in that** a gas flow on the first radial bearing (3) and a gas flow on the second radial bearing (4) are selected, in particular, variously selected, so that an approximately equal bearing stiffness of both radial bearings (3, 4) is achieved.

## Revendications

1. Système (100) à rotor RMN-RAM, comprenant un rotor (1) conçu pour recevoir une substance (40) à mesurer, et un stator (2) dévolu au montage rotatif dudit rotor (1) autour d'un axe de rotation (RA),
un premier palier radial pneumatique (3) muni de premiers ajutages de sortie (11) pratiqués dans le stator (2) et présentant un rayon r1, et d'une première surface d'appui (10) présentant un rayon R1 sur un tronçon cylindrique circulaire (6) du rotor (1), un second palier radial pneumatique (4) pourvu de deuxièmes ajutages de sortie (12) pratiqués dans le stator (2) et présentant un rayon r2 et, sur le rotor (1), d'une deuxième surface d'appui (13) présentant un rayon R2 mesuré par rapport auxdits deuxièmes ajutages de sortie (12) pratiqués dans ledit stator (2),
et un palier axial pneumatique (5) incluant au moins un ajutage de sortie (15) pratiqué dans ledit stator (2), et une troisième surface d'appui (14) au niveau d'une extrémité axiale dudit rotor (1), laquelle troisième surface d'appui (14) s'étend orthogonalement vis-à-vis de l'axe de rotation (RA) et présente un rayon extérieur R3,
**caractérisé par le fait**
**que** le second palier radial (4) est ménagé au niveau d'une région extrême (7) du rotor (1), dotée d'un rayon qui est inférieur à celui du tronçon cylindrique circulaire (6) ou qui diminue en s'éloignant dudit tronçon cylindrique circulaire (6), de sorte que R2 < R1 et que, par ailleurs, r2 < r1 ;
et par le fait que la troisième surface d'appui (14) est ménagée au niveau d'une extrémité de ladite région extrême (7) qui pointe à l'opposé dudit tronçon cylindrique circulaire (6), de sorte que, par ailleurs, R3 ≤ R2.

2. Système (100) à rotor, selon la revendication 1, **caractérisé par le fait que** la région extrême (7) est de réalisation cylindrique circulaire, au moins en partie.

3. Système (100) à rotor, selon la revendication 1 ou 2, **caractérisé par le fait que** la région extrême (7) est de réalisation tronconique, au moins en partie.

4. Système (100) à rotor, selon la revendication 3, **caractérisé par le fait que** la région extrême (7) s'étend au moins en partie suivant un angle α par rapport à l'axe de rotation (RA), sachant que 15° ≤ α ≤ 45°.

5. Système (100) à rotor, selon l'une des revendications précédentes, **caractérisé par le fait que** le stator (2) ceinture, en forme de calice, la troisième surface d'appui (14) et au moins une partie adjacente de la région extrême (7), préférentiellement l'intégralité de ladite région extrême (7), des orifices (34) de sortie d'air étant prévus, dans ledit stator (2), dans la zone de ladite troisième surface d'appui (14) et/ou de ladite région extrême (7).

6. Système (100) à rotor, selon l'une des revendications précédentes, **caractérisé par le fait que** la région extrême (7) s'étend sur 1/4 de la longueur du rotor (1), ou moins, et/ou couvre au moins 1/20 de la longueur dudit rotor (1).

7. Système (100) à rotor, selon l'une des revendications précédentes, **caractérisé par le fait que** le rotor (1) est muni, au niveau d'une extrémité pointant à l'opposé de la troisième surface d'appui (14), d'un orifice (8) affecté à l'emplissage dudit rotor (1) par une substance (40) à mesurer ; et **par le fait que** ledit rotor (1) comporte un capuchon (9) qui obture ledit orifice (8) dudit rotor (1).

8. Système (100) à rotor, selon la revendication 7, **caractérisé par le fait que** des structures complémentaires (9a), en particulier des surfaces formant chicanes, des surfaces formant ailettes ou des rainures hélicoïdales, sont façonnées au niveau du capuchon (9) en vue d'un entraînement pneumatique (22) du rotor (1).

9. Système (100) à rotor, selon la revendication 7 ou 8, **caractérisé par le fait qu'**un rayon extérieur R4 du capuchon (9) correspond, pour l'essentiel, au rayon R1.

10. Système (100) à rotor, selon l'une des revendications 7 à 9, **caractérisé par le fait que** le tronçon cylindrique circulaire (6) s'étend jusqu'à l'orifice (8) à partir de la région extrême (7).

11. Système (100) à rotor, selon l'une des revendications précédentes, **caractérisé par le fait que** le rotor (1) est de réalisation fermée dans la région de la troisième surface d'appui (14).

12. Système (100) à rotor, selon l'une des revendications précédentes, **caractérisé par le fait que** ledit système (100) à rotor est pourvu, en outre, d'un contrepalier (35) situé en vis-à-vis du palier axial (5).

13. Dispositif (200) à tête de sonde, comprenant un système (100) à rotor conforme à l'une des revendications précédentes, ainsi qu'un agencement de bobine HF (21) destiné à diffuser des impulsions HF dans la substance à mesurer renfermée par le rotor (1), et/ou à recevoir des signaux HF émanant de ladite substance (40) à mesurer, renfermée par ledit rotor (1),
le stator (2) comprenant une première embase de montage (17) incluant une partie du premier palier radial (3), située côté stator, un élément d'enveloppement (16) et une seconde embase de montage (18) incluant une partie du second palier radial (4) située côté stator,
l'élément d'enveloppement (16) reliant l'une à l'autre ladite première embase de montage (17) et ladite seconde embase de montage (18),
ledit élément d'enveloppement (16) comportant un segment antérieur (19), qui se rattache à ladite seconde embase de montage (18) et est pourvu d'un diamètre extérieur maximal ADV,
ladite seconde embase de montage (18) étant pourvue d'un diamètre extérieur maximal AD2,
le stator (2) présentant un diamètre extérieur maximal AD1 dans la région du premier palier radial (3),
et ledit agencement de bobine HF (21) étant pourvu d'un diamètre intérieur minimal IDS, sachant que AD1 > IDS, ADV < IDS et AD2 < IDS.

14. Dispositif (200) à tête de sonde, selon la revendication 13, **caractérisé par le fait que** l'élément d'enveloppement (16) est de réalisation étanche aux gaz.

15. Dispositif (200) à tête de sonde, selon la revendication 14, **caractérisé par le fait que** l'agencement de bobine HF (21) est refroidi jusqu'à une température cryogénique T, sachant notamment que T ≤ 100 K, que T ≤ 40 K de préférence ; et/ou **par le fait que** ledit dispositif à tête de sonde inclut un espace soumis à dépression dans lequel ledit agencement de bobine HF (21) est logé, et qui est conjointement délimité par l'élément d'enveloppement (16).

16. Utilisation d'un système (100) à rotor, conforme à l'une des revendications 1 à 12, ou d'un dispositif (200) à tête de sonde, conforme à l'une des revendications 13 à 15, pour mesurer une substance (40) déversée dans ledit rotor (1) lors d'une expérience RMN-RAM, sachant que le rotor (1) est disposé dans le stator (2) et que ledit rotor (1) tourne autour de l'axe de rotation (RA), de préférence à une fréquence d'au moins 1 kHz, et à une fréquence d'au moins 10 kHz avec préférence particulière.

17. Utilisation selon la revendication 16, **caractérisée par le fait qu'**un flux gazeux au niveau du premier palier radial (3), et un flux gazeux au niveau du second palier radial (4), sont choisis de façon telle, notamment avec une différence telle qu'une rigidité approximativement identique des deux paliers radiaux (3, 4) soit obtenue.
